# EUROPÄISCHE PATENTSCHRIFT

(11) **EP 3 551 490 B1**
(45) Veröffentlichungstag und Bekanntmachung des Hinweises auf die Patenterteilung: **13.01.2021**
(21) Anmeldenummer: 17811491.4
(22) Anmeldetag: 23.11.2017
(51) Int. Cl.: B60K 35/00, B60R 11/02, G02F 1/1333, G02F 1/1347, G06F 1/16, H01L 51/00, B60R 11/00

(54) **ANZEIGEVORRICHTUNG FÜR EIN KRAFTFAHRZEUG**
DISPLAY DEVICE FOR A MOTOR VEHICLE
DISPOSITIF D'AFFICHAGE POUR UN VÉHICULE AUTOMOBILE

(30) Priorität: 08.12.2016 DE 102016224500
(43) Veröffentlichungstag der Anmeldung: 16.10.2019
(73) Patentinhaber: Audi AG, 85045 Ingolstadt (DE)
(72) Erfinder: REDEKER, Immo, 85051 Ingolstadt (DE); HÉLOT, Jacques, 85051 Ingolstadt (DE); MERTENS, Joris, 85051 Ingolstadt (DE)
(86) Internationale Anmeldenummer: PCT/EP2017/080225
(87) Internationale Veröffentlichungsnummer: WO 2018/104067

(56) Entgegenhaltungen:
- WO-A1-98/09842
- DE-A1-102012 010 679
- DE-A1-102014 016 323
- US-A- 5 847 685

## Beschreibung

Die Erfindung betrifft eine Anzeigevorrichtung für ein Kraftfahrzeug mit einer Anzeigeflächeneinrichtung, wobei die Anzeigeflächeneinrichtung eine Anzeigefläche zum Anzeigen eines Anzeigeninhaltes aufweist. Eine Anzeigevorrichtung ist dabei ein Gerät oder eine Gerätekomponente, die zum Anzeigen eines Bildinhaltes ausgestaltet ist, zum Beispiel ein Bildschirm. Die Anzeigeflächeneinrichtung ist dabei dasjenige Bauteil, das die Anzeigefläche bildet oder umfasst.

Moderne Kraftfahrzeuge haben meist eine Benutzerschnittstelle, die zum Beispiel dazu dienen kann, mit dem Kraftfahrzeug zu kommunizieren. Eine solche Benutzerschnittstelle hat einen Bildschirm, um zum Beispiel Menüfunktionen zur Auswahl bereit zu stellen. Andere Bildschirme, wie beispielsweise der eines Kombiinstruments, dienen zur Anzeige von wichtigen Informationen während des Betriebs des Kraftfahrzeugs. Geläufig sind dabei Kombiinstrumente und Infotainmentsysteme, die relativ viel Bauraum erfordern. Für einen zusätzlichen Anzeigeinhalt kann das Kraftfahrzeug nachgerüstet werden, in dem zum Beispiel ein separater Bildschirm, zum Beispiel ein sogenanntes zusätzliches "After-Market-Display" zum Anzeigen zusätzlicher Inhalte an zum Beispiel an einer Windschutzscheibe des Kraftfahrzeugs angebracht werden können. Das Angebot an Bildschirminhalten ist heutzutage also abhängig durch eine fixe, limitierte Anzeigegröße.

Insbesondere bei der Verwendung von zusätzlichen Bildschirmen ergibt sich ein optisches Durcheinander und für den Kraftfahrzeughersteller der Nachteil, dass er sich zu seinem Mitbewerber nicht unterscheiden kann. Durch das optische Durcheinander ergibt sich eine Unübersichtlichkeit, die ein schnelles Auffinden eines bestimmten Anzeigeninhaltes erschwert.

Aus der US2012/0268665 A1 ist ein Bildschirm bekannt, der an einer Rückseite einer Kopfstütze des Fahrersitzes oder Beifahrersitzes angeordnet sein kann. Dies dient der Information eines Passagiers auf einer Rückbank. Um Bauraum zu sparen, kann der Bildschirm als Leinwand ausgestaltet sein, die in einem Schacht des Kraftfahrzeugsitzes aufgerollt werden kann. Alternativ kann der Bildschirm, ähnlich einer Leinwand für eine Diaprojektion, in der Kopfstütze aufgerollt oder in einem Dachhimmel verstaut werden. Ein solcher Bildschirm erfordert wenig Bauraum, wenn der Bildschirm nicht genutzt wird, bei einer Inbetriebnahme kann jedoch nur die volle Größe der Bildschirmfläche beansprucht werden.

Ein dehnbarer Bildschirm eines mobilen elektronischen Gerätes aus der WO 2015/140785 A1 bekannt, wobei der Bildschirm aus einem elastischen Material ist und gebogen werden kann. In einem gestreckten Zustand kann der Bildschirm benutzt werden. Durch die Elastizität ergibt sich hierbei jedoch das gleiche Problem wie aus dem Bildschirm das weiter oben genannten Stands der Technik, da ein elastisches Material in einem gestreckten Zustand unter Zug steht und deswegen nur vollständig ausgedehnt oder vollständig verstaut werden kann. Davon abgesehen bietet die WO 2015/140785 A1 keine Anwendungsmöglichkeit in einem Kraftfahrzeug, denn das Verwenden eines elastischen Bildschirms in einem Kraftfahrzeug bedingt das zusätzliche Problem, dass bei einer Benutzung der Bildschirm fest gehalten werden muss und unter Umständen in einen Stauraum zurückschnappt, wenn der Fahrer beispielsweise aus Versehen die Arretierung gelöst. Die Benutzung eines solchen elastischen Bildschirms ist somit für einen Benutzer eines Kraftfahrzeugs sehr problematisch und berücksichtigt nicht, dass zum Beispiel ein Fahrer seine Aufmerksamkeit vornehmlich auf das Fahrgeschehen wenden soll.

Die US2013/0222276 A1 beschreibt ebenfalls ein flexibles Display, das gebogen werden kann, also gegen einen elastischen Widerstand in seiner Form verändert werden kann. Auch hier ergeben sich die oben genannten Nachteile.

Die DE 10 2012 010 679 A1 offenbart eine Anzeigeeinrichtung für ein Kraftfahrzeug, die ein Anzeigefeld und eine Verformungsvorrichtung aufweist, wobei das Anzeigefeld zum Darstellen eines Anzeigeinhalts ausgebildet und aus einem elastisch verformbaren Material gebildet ist, wobei die Verformungsvorrichtung dazu ausgebildet ist, das Anzeigefeld in Abhängigkeit einer Anzeigebedingung zu verformen.

Die WO 98/09842 A1 offenbart ein System zum Anzeigen von elektronisch erzeugten Bildern innerhalb eines Fahrzeugs, das zwei Anzeigebildschirme umfasst, wobei der ein Anzeigebildschirm Bilder für den Fahrer anzeigt und der zweite Anzeigebildschirm Bilder für einen Passagier des Fahrzeugs erzeugt. Die Bilder der beiden Anzeigebildschirme werden unabhängig voneinander erzeugt.

Die US 5 847 685 A offenbart ein Anzeige, die eine aus einem festen Gehäuse in einer horizontalen Stellung projiziert und dann rotiert zu einer aufgerichteten Stellung wird, wobei ein Ende der Anzeige daran gehindert wird außerhalb des festen Gehäuses zu projizieren.

Die DE 10 2014 016 323 A1 offenbart eine Anzeigevorrichtung für einen Kraftwagen, mit einer flexiblen Anzeigeeinrichtung und mit einer Verstelleinrichtung, welche dazu ausgebildet ist, die Anzeigeeinrichtung von einer Verstauposition in eine Gebrauchsposition zu bewegen, wobei die Verstelleinrichtung dazu ausgebildet ist, die Anzeigeeinrichtung von der Verstauposition in die Gebrauchsposition zu biegen.

Eine der Erfindung zu Grunde liegende Aufgabe ist das Bereitstellen einer platzsparenden Anzeigevorrichtung, die die oben genannten Nachteile reduziert.

Die Aufgabe wird durch die erfindungsgemäßen Gegenstände und das erfindungsgemäße Verfahren der nebengeordneten Patentansprüche gelöst. Vorteilhafte Weiterbildungen ergeben sich durch die Unteransprüche.

Die Erfindung basiert auf der Idee, eine Anzeigefläche durch Aufblättern oder Falten zu vergrößern, beziehungsweise zu verkleinern. Die Anzeigefläche dominiert dann nicht unnötig einen Innenraum des Kraftfahrzeugs und beansprucht weniger Bauraum. Außerdem werden die oben genannten Nachteile bei der Handhabung der Anzeigevorrichtung reduziert.

Die erfindungsgemäße Anzeigevorrichtung für ein Kraftfahrzeug kann beispielsweise als Bildschirm ausgestaltet sein, und weist eine Anzeigeflächeneinrichtung mit einer Anzeigefläche zum Anzeigen eines Anzeigeninhaltes auf. Die Anzeigeflächeneinrichtung weist mindestens zwei Anzeigebereiche auf. Die erfindungsgemäße Anzeigevorrichtung ist gekennzeichnet durch eine Falteinrichtung, die dazu eingerichtet ist, die Anzeigeflächeneinrichtung - und damit die Anzeigefläche - zu falten oder zu klappen. Im Gegensatz zu einem "Biegen" oder "Dehnen" erfolgt ein Falten oder Klappen ohne Zug, sodass die Anzeigeflächeneinrichtung nicht gegen einen elastischen Widerstand verformt wird. Das Wort "faltbar" kann deswegen auch als "beweglich" oder "klappbar" verstanden werden. Unter einer Falteinrichtung wird im Sinne der Erfindung eine Gerätekomponente oder ein Bauteil verstanden, die/das dazu ausgestaltet ist, die Anzeigeflächeneinrichtung zu falten oder zu klappen, das heißt zwei Anzeigenbereiche der Anzeigeflächeneinrichtung bzw. der Anzeigefläche gegeneinander zu bewegen, ohne dass dies gegen einen elastischen Widerstand geschieht. Die Falteinrichtung kann deswegen auch als "Klappeinrichtung" bezeichnet werden. Eine Anzeigeflächeneinrichtung kann beispielsweise einen Bildschirm aufweisen, dessen Form derart verändert werden kann, dass das Verformen ohne elastischen Widerstand erfolgt.

Durch die erfindungsgemäße Anzeigevorrichtung werden die oben genannten Nachteile reduziert oder sogar behoben, und es ergeben sich die bereits genannten Vorteile. Dadurch, dass die Anzeigeflächeneinrichtung gefaltet, jedoch nicht gebogen oder gedehnt wird, ergibt sich der zusätzliche Vorteil, dass ein Faltwinkel oder Klappwinkel zwischen zwei Anzeigebereichen frei wählbar sein kann. Die Anzeigevorrichtung benötigt weniger Bauraum, bietet jedoch zusätzlichen Platz zum Anzeigen von zusätzlichen Informationen. Als weiterer Vorteil ergibt sich, dass die Anzeigefläche je nach einem aktuellen Bedürfnis vergrößert oder verkleinert werden kann.

Die Falteinrichtung kann beispielsweise und nicht-erfindungsgemäß als Gelenk oder Scharnier zwischen den zwei Anzeigebereichen der Anzeigeflächeneinrichtung ausgestaltet sein. Dies stellt eine besonders einfache und kostengünstige Variante der erfindungsgemäßen Anzeigevorrichtung dar.

Erfindungsgemäß weist die Falteinrichtung ein Schienenelement auf, das parallel zu einer Erstreckungsrichtung eines der Anzeigebereiche der Anzeigeflächeneinrichtung verläuft und parallel hierzu verschiebbar gelagert ist. Als Schienenelement wird dabei ein Bauteil mit einer Schienenfunktion angesehen, und beispielsweise als Schiene ausgestaltet und auf einer weiteren, stationären Schiene mit Rastelementen verschiebbar gelagert sein. Über beispielsweise einen Ritzel an dem Schienenelement kann ein solches, beispielhaftes Schienenelement parallel zu der Erstreckungsrichtung eines der beiden Anzeigebereiche, oder, falls die Anzeigefläche vollständig auf gefaltet ist, parallel zu beiden Anzeigebereichen verschoben werden.

Die Falteinrichtung dieser Ausführungsform der erfindungsgemäßen Anzeigevorrichtung weist ein Hebelelement auf, das vorzugsweise als Bogen ausgestaltet sein kann, und das ein erstes Ende und ein zweites Ende hat, wobei das erste Ende an dem Schienenelement angeordnet, vorzugsweise beweglich gelagert, ist. Das Hebelelement, also ein Bauteil, das in einem montierten Zustand eine Hebelfunktion ausüben kann, kann an seinem zweiten Ende an mindestens einem Halteelement angeordnet sein, wobei das Halteelement ebenfalls ein Bestandteil der Falteinrichtung und an einem faltbaren Anzeigebereich der Anzeigeflächeneinrichtung fest angeordnet sein kann. An dem zweiten Ende des Hebelelements ist das mindestens eine Halteelement angeordnet, vorzugsweise beweglich gelagert.

Eine solche Konstruktion stellt eine besonders effiziente Möglichkeit dar, stufenfrei einen vorbestimmten Anteil der Anzeigefläche zur Verfügung zu stellen. Eine solche mechanische Konstruktion kann beispielsweise durch einen elektronisch gesteuerten Elektromotor angetrieben werden.

Gemäß einer Weiterbildung kann das mindestens eine Halteelement an einer dem Schienenelement zugewandten Seite des faltbaren Anzeigebereichs und/oder an einem freien Ende und/oder an einer Kante des faltbaren Anzeigebereichs angeordnet sein. Dies sind verschiedene Varianten, die ein einfaches Falten der Anzeigefläche ermöglichen.

Gemäß einer weiteren Weiterbildung kann vorgesehen sein, dass ein erstes Ende des Schienenelements und der faltbare Anzeigebereich, an dem das Halteelement angeordnet ist, auf der gleichen Seite der Anzeigeflächeneinrichtung angeordnet sind. Dies ist eine besonders effiziente Konstruktion der Falteinrichtung.

Die Falteinrichtung kann zusätzlich oder alternativ ein Klammerelement aufweisen, also ein Bauteil mit einer Klammerwirkung, das einen Teilbereich eines Endes der Anzeigeflächeneinrichtung umfassen kann. Dies dient der zusätzlichen Halterung der Anzeigeflächeneinrichtung und bildet eine besonders bauraumsparende Konstruktion der Anzeigeflächeneinrichtung.

Für die Anzeigevorrichtung kann gemäß einer weiteren Ausführungsform vorgesehen sein, dass sie eine Steuereinrichtung aufweist, also ein Bauteil oder eine Gerätekomponente zum elektronischen Steuern der Anzeigevorrichtung, wobei die Steuereinrichtung dazu eingerichtet sein kann, in Abhängigkeit von einem eine Bedienhandlung beschreibenden Bediensignal einen durch das Bediensignal beschriebenen Faltwinkel oder Klappwinkel zwischen beiden Anzeigebereichen der Anzeigeflächeneinrichtung einzustellen. Hierdurch kann durch das Falten der für den Benutzer verfügbare Anteil der Anzeigefläche benutzerspezifisch eingestellt werden.

Die oben gestellte Aufgabe wird ebenfalls gelöst von einem Kraftfahrzeug, das vorzugsweise als Kraftwagen, zum Beispiel als Personenkraftwagen ausgestaltet sein kann. Das erfindungsgemäße Kraftfahrzeug ist gekennzeichnet durch eine Ausführungsform der erfindungsgemäßen Anzeigevorrichtung mit einer Anzeigeflächeneinrichtung, die vorzugsweise in einer Schalttafel und/oder in einer Mittelkonsole des Kraftfahrzeugs angeordnet sein kann. Hierdurch werden die oben genannten Vorteile erreicht.

Die oben gestellte Aufgabe wird ebenfalls gelöst durch ein Verfahren zum Betreiben einer Ausführungsform der erfindungsgemäßen Anzeigevorrichtung, aufweisend die Verfahrensschritte: Empfangen eines Bediensignals durch die Steuereinrichtung der Anzeigevorrichtung, wobei das Bediensignal eine Bedienhandlung eines Benutzers der Anzeigevorrichtung beschreibt, in Abhängigkeit von dem empfangenen Bediensignal, Erzeugen eines Steuersignals zum Steuern der Falteinrichtung in Abhängigkeit von den Bediensignal, und Einstellen eines Klappwinkels zwischen beiden Anzeigebereichen durch die Falteinrichtung in Abhängigkeit von dem Steuersignal. Auch hier ergeben sich die oben genannten Vorteile.

Zu der Erfindung gehören auch Weiterbildungen des erfindungsgemäßen Verfahrens, die Merkmale aufweisen, wie sie bereits im Zusammenhang mit den Weiterbildungen des erfindungsgemäßen Kraftfahrzeugs beschrieben worden sind. Aus diesem Grund sind die entsprechenden Weiterbildungen des erfindungsgemäßen Verfahrens hier nicht noch einmal beschrieben.

Im Folgenden ist ein Ausführungsbeispiel der Erfindung beschrieben. Hierzu zeigt:
- Fig. 1a, 1b, 1c: jeweils eine schematische Skizze zu einer Ausführungsform einer nicht-erfindungsgemäßen Anzeigevorrichtung und einem nicht-erfindungsgemäßen Verfahren,
- Fig. 2a, 2b, 2c: jeweils eine schematische Skizze zu einer Ausführungsform einer nicht-erfindungsgemäßen Anzeigevorrichtung und einem nicht-erfindungsgemäßen Verfahren,
- Fig. 3: eine schematische Skizze zu einer Ausführungsform der erfindungsgemäßen Anzeigevorrichtung,
- Fig. 4a, 4b: jeweils eine schematische Skizze zu einer Ausführungsform der erfindungsgemäßen Anzeigevorrichtung und des erfindungsgemäßen Verfahren,
- Fig. 5a, 5b, 5c: jeweils eine schematische Skizze zu einer Ausführungsform der erfindungsgemäßen Anzeigevorrichtung und des erfindungsgemäßen Verfahren, und
- Fig. 6a, 6b, 6c: jeweils eine schematische Skizze zu einer Ausführungsform der erfindungsgemäßen Anzeigevorrichtung und des erfindungsgemäßen Verfahren.

In den Figuren sind funktionsgleiche Elemente jeweils mit denselben Bezugszeichen versehen.

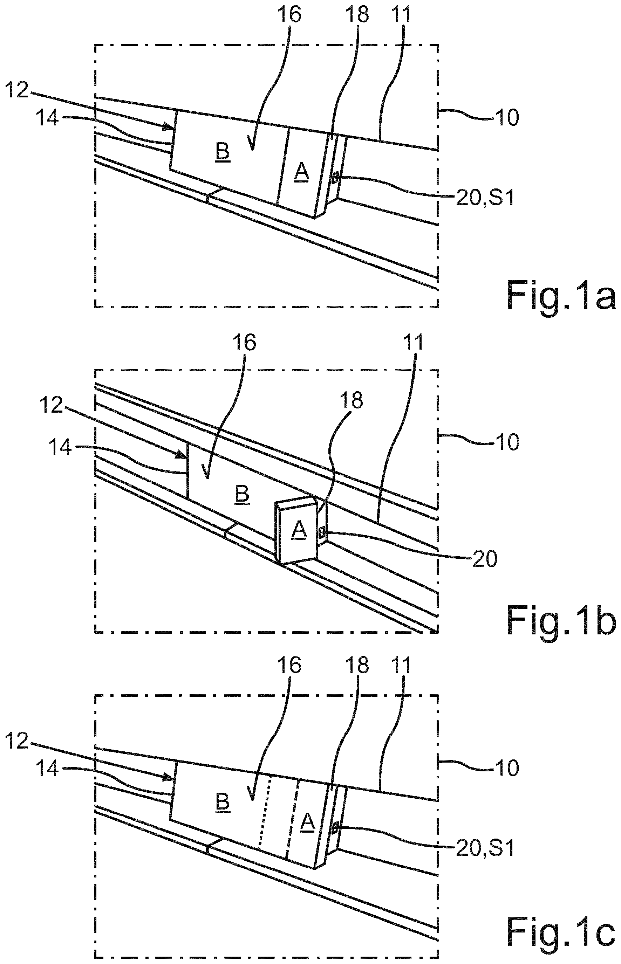

Die Fig. 1a, 1b und 1c veranschaulichen anhand eines ersten Ausführungsbeispiels das Prinzip einer Anzeigevorrichtung und eines Verfahren zum Betreiben einer solchen Anzeigevorrichtung.

Hierzu zeigen die genannten Figuren ein Kraftfahrzeug 10, dass beispielsweise als Kraftwagen, zum Beispiel als Personenkraftwagen ausgestaltet sein kann. Das Kraftfahrzeug 10 hatte beispielsweise ein Innenraumausstattungselement 11, beispielsweise eine Mittelkonsole oder eine Schalter, in oder an der die erfindungsgemäße Anzeigevorrichtung 12 angeordnet sein kann. Die Anzeigevorrichtung 12 kann dabei beispielsweise in eine schienenartige Einbuchtung des Innenraumausstattungselements 11 angeordnet sein. Beispielsweise kann die Anzeigevorrichtung 12 als Gerät mit einem Bildschirm ausgestaltet und kann hierzu zum Beispiel entsprechendes Bauteil mit einer Anzeigefläche 16 bereitstellen. Eine solche Anzeigeflächeneinrichtung 14 kann beispielsweise als berührungssensitiver Bildschirm ausgestaltet sein. Beispielhafte Anzeigeflächeneinrichtungen 14 sind in dem Fachmann aus dem Stand der Technik bekannt, beispielsweise aus der die DE 10 2014 016 323 A1. Diese beschreibt einen farbigen Bildschirm mit organischen Leuchtdioden ("OLED-Display") mit einer flexiblen Ausgestaltung aus biegsamen Glas oder biegsamen Plexiglas.

Die Anzeigeflächeneinrichtung 14 stellt die Anzeigefläche 16 bereit, auf der Anzeigeelemente, also zum Beispiel ein Text oder Bilder, angezeigt werden können. Die Anzeigeflächeneinrichtung 14 hat dabei mindestens zwei Anzeigebereiche A, B. Folglich hat auch die Anzeigefläche 16 mindestens zwei Anzeigebereiche A, B. Die Fig. 1a zeigte dabei einen gefalteten Anzeigenbereich A, und einen weiteren Anzeigebereich B. Fig. 1c zeigte die Anzeigebereiche A und B, wobei die Anzeigeflächeneinrichtung 14 entfaltet oder aufgeklappt ist. Die gepunktete Linie veranschaulicht dabei die Grenze zwischen den beiden Anzeigebereichen A, B, während die gestrichelte Linie der Fig. 1c den Bereiche markiert, an dem der Anzeigebereich A gefaltet oder geklappt wurde. Im Beispiel der Fig. 1a, 1B, und 1c können dabei die Flächen der beiden Anzeigenbereiche B und A in einem Verhältnis von beispielsweise 2:1 zueinander stehen.

Die Anzeigevorrichtung 12 weist ebenfalls eine Falteinrichtung 18 auf, die auch als Klappeinrichtung bezeichnet werden kann. Im Beispiel der Fig. 1a, 1b und 1c kann die Falteinrichtung 18 beispielsweise als Gelenk zwischen den 2 Anzeigebereichen A, B ausgestaltet sein, oder als Scharnier.

Die Falteinrichtung 18 kann optional mechanisch und/oder elektronisch verstellt und damit gesteuert werden. Hierzu zeigt die Anzeigevorrichtung 12 der Fig. 1a, 1b, und 1c eine Steuereinrichtung 20, die beispielsweise als Steuerplatine ausgestaltet und zum Beispiel einen Mikroprozessor und/oder einen Mikrokontroller aufweisen kann. Die Steuereinrichtung 20 kann beispielsweise durch einen drahtgebundene Kommunikationsverbindung, beispielsweise einen Draht oder einen Datenbus, mit der Falteinrichtung 18 und/oder mit einem Elektromotor zum Steuern der Falteinrichtung 18 verbunden sein. Ein optionaler Elektromotor ist dabei in den Beispielen der Fig. 1a, 1b, 1c nicht gezeigt.

In dem Beispiel der Fig. 1a, 1b und 1c kann das Kraftfahrzeug 10 beispielsweise über ein sogenanntes "Multimedia-Interface" aufweisen, also ein Benutzerschnittstelle, über die einem Benutzer zum Beispiel ein Menü mit verschiedenen Kraftfahrzeugfunktionen angezeigt werden kann und über die der Benutzer zum Beispiel durch eine Bedienhandlung die Funktionen steuern kann.

Zum Beispiel bei einer Nachtfahrt gibt ein Bildschirm des Multimedia-Interfaces Licht in einen Innenraum des KraftfahrzeugS10 ab. Das Kraftfahrzeug 10 kann beispielsweise zusätzlich ein Kombiinstrument aufweisen, das ebenfalls einen Bildschirm aufweisen kann. Bei Bedarf, möchte der Benutzer beispielsweise ein Menü für Funktionen des Komfortsystems gezeigt haben oder ein Navigationssystem starten, kann die Anzeigeflächeneinrichtung 14 der Anzeigevorrichtung 12, die baulich von dem Multimedia-Interface bzw. dem Kombiinstrument getrennt sein kann, aktivieren und zum Beispiel den in einem Ruhezustand gefalteten Anzeigenbereich A entfalten oder aufklappen.

Wird beispielsweise die Anzeigevorrichtung 12 nicht mehr gebraucht, so kann der Anzeigebereich A zum Beispiel wieder eingeklappt werden, so dass eine geringere Gesamtfläche der Anzeigefläche 16 zu sehen ist und somit auch weniger Licht in den Innenraum des Kraftfahrzeugs 10 abgegeben wird. Dadurch wird dann in einem Ruhezustand in der Anzeigevorrichtung 12 die Beleuchtung in den Innenraum ruhiger, was auf den Fahrer beruhigend wirken kann und womit dieser weniger abgelenkt wird. Der Mechanismus der Anzeigevorrichtung 12 sorgt zusätzlich für einen erstaunlichen Effekt, der dem Benutzer den Spaß an der Bedienung der Anzeigevorrichtung 12 erhöht.

Alternativ zu dem genannten Beispiel, gemäß dem die Falteinrichtung 18 elektrisch und/oder elektronisch gesteuert werden kann, kann auch ein rein mechanischer Klappmechanismus durch eine entsprechende Ausgestaltung der Falteinrichtung 18 vorgesehen sein, bei dem zum Beispiel bei einem mechanischen Drücken auf einen eingeklappten Anzeigenbereich A ein mechanisches Auffalten erfolgen kann, so dass die komplette Anzeigefläche 16 sichtbar ist. Hierzu kann die Falteinrichtung 18 beispielsweise einen bekannten Federmechanismus und eine Arretierung aufweisen.

Möchte der Benutzer beispielsweise eine Klimafunktion eine Klimaanlage des Kraftfahrzeugs benutzen, kann er beispielsweise die Anzeigefläche 16 vergrößern wollen, um auf dem aufgeklappt Anzeigenbereich A beispielsweise entsprechende Anzeigeelemente zum Bedienen der Klimaanlage darstellen zu lassen. Durch zum Beispiel ein mechanisches Drücken oder zum Beispiel eine Bedienhandlung, die beispielsweise ein Berühren einer berührungssensitives Anzeigefläche 16 oder eines entsprechenden Bedienelements zum Beispiel eines Multimedia-Interfaces sein kann, kann die Falteinrichtung 18 mechanisch und/oder elektronisch betätigt werden.

Die Steuereinrichtung 20 kann bei einer elektronischen Steuerung hierzu in einem ersten Verfahrensschritt S1 ein Bediensignal empfangen, dass die Bedienhandlung beschreiben kann. In Abhängigkeit von dem empfangenen Beginn Signal kann die Steuereinrichtung im Verfahrensschritt S2 ein Steuersignal erzeugen, dass beispielsweise an einen Elektromotor (in den Fig. 1a, 1b, 1c nicht gezeigt) übertragen werden kann, und der beispielhafte Elektromotor kann die Falteinrichtung 18 derart steuern werden, dass zwischen den beiden Anzeigebereichen A, B beispielsweise ein Klappwinkel oder Faltwinkel von 180° eingestellt werden kann (S3).

Hierzu zeigt die Fig. 1b den Vorgang des Aufklappens durch den Pfeil. Die Fig. 1c zeigt, wie bereits oben erwähnt, die auf aufgeklappte Anzeigeflächeneinrichtung 14, bzw. die aufgefaltete Anzeigeflächeneinrichtung 14 mit einem Klappwinkel oder Faltwinkel von zum Beispiel 180°. Alternativ kann beispielsweise die Steuereinrichtung 20 derart programmiert sein, dass ein Klappwinkel von beispielsweise 45° oder 35° eingestellt werden kann, wobei ein solcher Klappwinkel beispielsweise bewirken kann, dass der aufgeklappte Anzeigenbereich A der Anzeigeflächeneinrichtung 14 zum Beispiel in einem besonders günstigen Blickwinkel des Benutzers liegen kann.

Zusätzlich oder alternativ kann vorgesehen sein, dass das Einstellen des Klappwinkels (S3) zum Beispiel davon abhängt, wie lange der Benutzer die Bedienhandlung durchführt oder ob der Benutzer den aufklappenden Anzeigenbereich A berührt, um den Klappwinkel einzustellen.

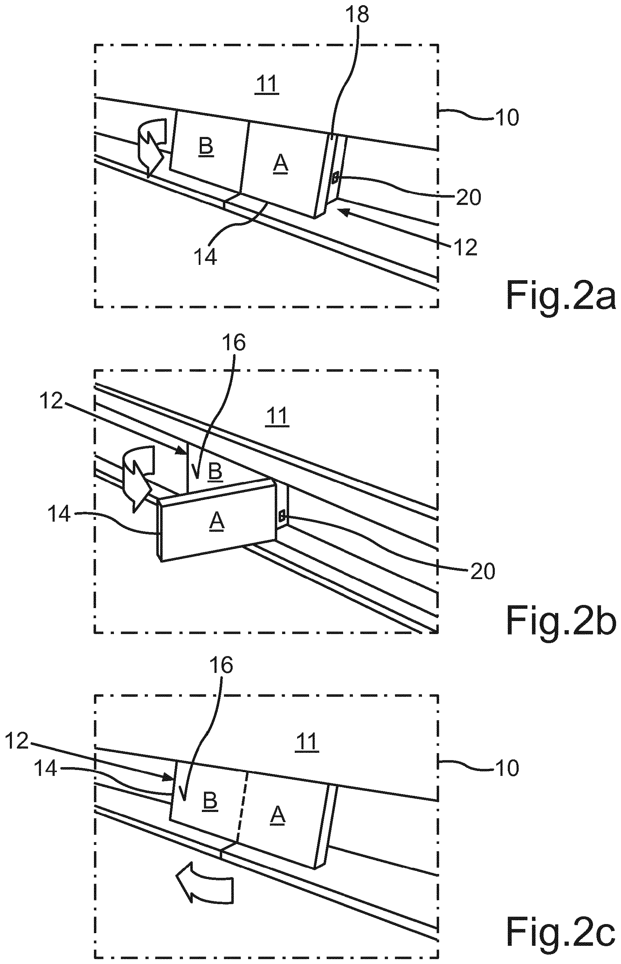

Die Fig. 2a, 2b und 2c veranschaulichen ein weiteres Ausführungsbeispiel, das demjenigen der Fig. 1a, 1b und 1c weitestgehend entsprechen kann, wobei im Folgenden nur die Abweichungen beschrieben werden.

Im Beispiel der Fig. 2a, 2b, 2c kann ein Verhältnis der Flächen der Anzeigebereiche B zu A beispielsweise 1:1 sein. Der Pfeil in der Fig. 2b veranschaulicht dabei das Aufklappen oder Auffalten des Anzeigenbereich A, während der Pfeil in der Fig. 2c die Richtung angezeigt, in der Anzeigenbereich A wieder eingeklappt oder eingefaltet werden kann.

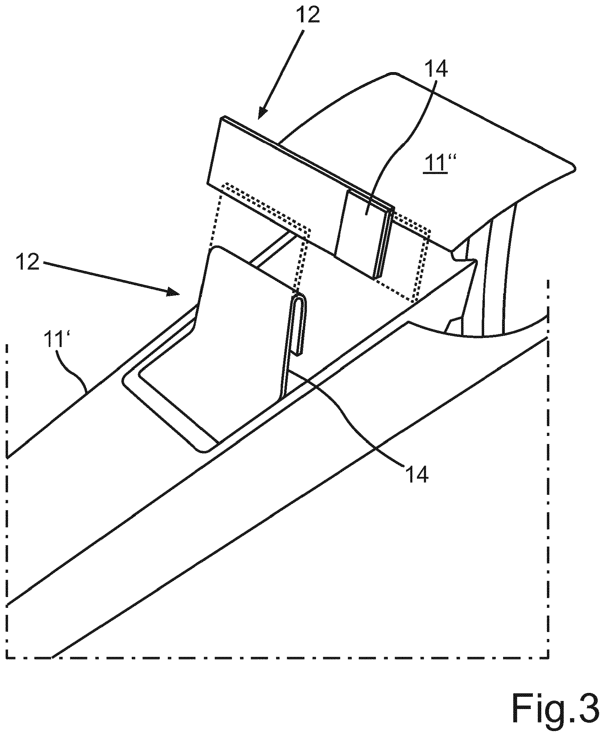

Die Fig. 3 veranschaulicht erfindungsgemäße Ausführungsbeispiele einer Anzeigevorrichtung 12, wobei beispielsweise eine Anzeigevorrichtung 12 in einer Mittelkonsole 11' und eine weitere Anzeigevorrichtung 12 zum Beispiel in einer Instrumententafel oder Schalttafel 11" angeordnet sein können. Die jeweilige Anzeigevorrichtung 12 kann dabei beispielsweise wie in einem der oben beschriebenen Ausführungsbeispiele beschrieben ausgestaltet sein. Dabei zeigen die durch eine gepunktete Linie umrandeten Bereiche den jeweiligen Anzeigenbereich A, B in einer aufgefalteten oder aufgeklappten Erstreckung. Die Pfeile zeigen beispielhaft eine Klapp- oder Faltrichtung für einen der Anzeigebereiche A, B.

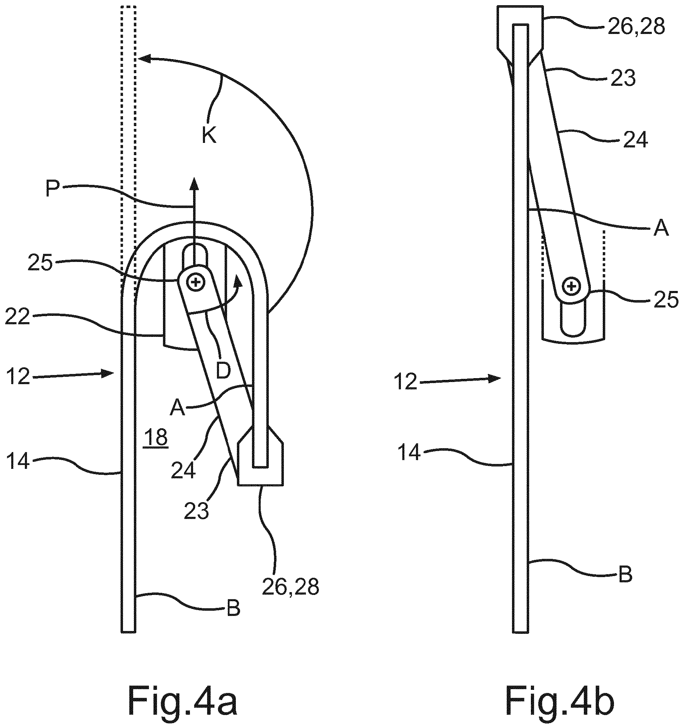

Die Fig. 4a und 4b veranschaulichen für das Beispiel der Anzeigevorrichtung 12 in der beispielhafte Mittelkonsole 11' aus der Fig. 3 einen beispielhaften Falt-oder Klappmechanismus. Die Fig. 4a zeigt hierzu die Anzeigevorrichtung 12 mit einem gefalteten Anzeigebereich A, wie in der Fig. 3. Die Falteinrichtung 18 kann hierzu beispielsweise ein Schienenelement 22, ein Hebelelement 24 und ein Halteelement 26 aufweisen. Das Schienenelement 22 kann beispielsweise als Platte mit einer länglichen Durchbohrung oder einem länglichen Loch ausgestaltet sein, entlang der ein erstes Ende 25 des Hebelelements 24 in die Richtung P und deren Gegenrichtung verschiebbar gelagert sein kann. Das Hebelelement 24, beispielsweise als Stange oder Platine ausgestaltet, kann an dem ersten Ende 25 beispielsweise eine Halterung aufweisen, die in die Durchbohrung des Schienenelements 22 eingefügt und in dieser beweglich gelagert sein kann.

An einem zweiten Ende 23 des Hebelelements 24 kann ein Halteelement 26 angeordnet sein, dass beispielsweise ein Teil des Hebelelements 24 sein kann, oder ein separates Bauteil. Im Beispiel der Fig. 4a und der Fig. 4b kann dabei das Halteelement 26 als Klammerelement oder Klemmelement ausgestaltet sein, dass ein Ende der Anzeigeflächeneinrichtung 14 umklammern oder umfassen kann.

Das Hebelelement 24 kann beispielsweise an dem Schienenelement 22 drehbar gelagert sein, sodass es zusätzlich zu dem Verschieben in die Richtung P und deren Gegenrichtung auch um eine Achse, die in der Fig. 4a und in der Fig. 4b als X gekennzeichnet ist, in die Richtung D - und/oder in die entsprechende Gegenrichtung - gedreht werden kann. Durch die Drehung D kann dann die Anzeigeflächeneinrichtung 14 in die Klapprichtung K aufgeklappt oder aufgefaltet werden. Die Fig. 4b zeigt die Konstruktion der Fig. 4a in einem aufgeklappten Zustand.

Im Beispiel der Fig. 4a und der Fig. 4b kann dabei das zweite Ende 23 des Hebelelements 24 beispielsweise fest an dem Halteelement 26 angeordnet sein, oder aber zum Beispiel in einem drehbaren Lager.

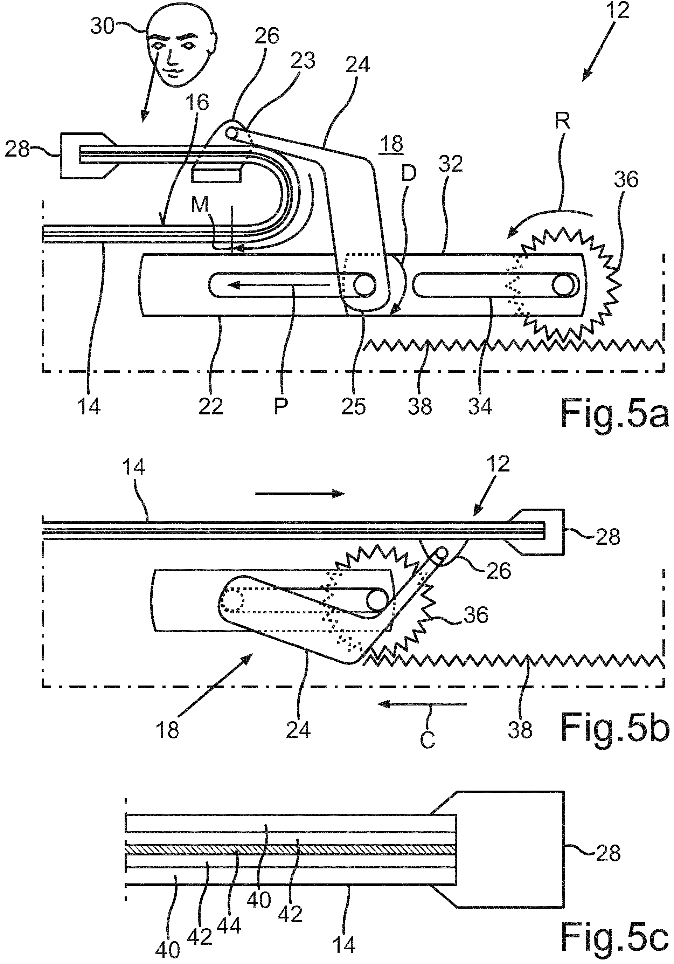

Die Figuren 5a, 5b und C zeigen ein weiteres Ausführungsbeispiel der erfindungsgemäßen Anzeigevorrichtung 12, wobei im Folgenden nur auf die Unterschiede zu den bisherigen Ausführungsbeispielen eingegangen wird. Die Figuren 5a, 5b und 5c heben dabei die Ausgestaltung der Falteinrichtung 18 hervor.

In der Fig. 5a ist dabei der Benutzer 30 gezeigt, der auf die Anzeigefläche 16 sieht, die beispielsweise als faltbares oder klappbares OLED-Display ausgestaltet sein kann. Der Pfeil Q und die Markierung M markieren dabei beispielhaft denjenigen Bereich der Anzeigefläche 16, an dem die beispielhaften OLEDs angebracht sein können. Die Anzeigeflächeneinrichtung 14 kann dabei an einem Ende ein Klammerelement 28 aufweisen, das die Anzeigeflächeneinrichtung 14 umfassen kann.

Das Hebelelement 24 kann beispielsweise als gebogener Arm ausgestaltet sein, der zum Beispiel beweglich an einem Halteelement 26 angeordnet sein kann. Ein entsprechendes Schienenelement 22 wurde bereits zuvor beschrieben. Zusätzlich kann das Schienenelement zum Beispiel eine Kassette 32 aufweisen, die, wie das Schienenelement 22, beispielsweise aus einem Kunststoff oder einem Metall gefertigt sein kann. Die Kassette 32 kann beispielsweise eine längliche Durchbohrung oder ein längliches Loch 34 aufweisen, in der zum Beispiel ein Ritzel 36 beweglich gelagert sein kann. Das beispielhafte Ritzel 36 kann sich zum Beispiel in die Richtung R drehen und sich dabei beispielsweise entlang einer Rastleiste 38, die zum Beispiel Rastelemente aufweisen kann, bewegen. Solche Rastelemente können beispielsweise als Zähne oder Nocken ausgestaltet sein, die mit den entsprechenden Vertiefungen des beispielhaften Ritzels 36 in Eingriff gelangen können. Durch die Drehbewegung R kann dann die Bewegung in die Richtung P erfolgen, wodurch eine Drehung D des Hebelelements 24 bewirkt werden kann.

Die Fig. 5b zeigt die Anzeigeflächeneinrichtung 14 in einem gespannten oder aufgefalteten Zustand, und die Anordnung der einzelnen Elemente der Falteinrichtung 18. Dabei zeigte der Pfeil C die Bewegungsrichtung der Kassette 32, wobei sich beim Bewegen der Kassette 32 gleichzeitig das Hebelelement 24 dreht.

Die Fig. 5c ist eine Detailansicht eines Endes der Anzeigenflächeneinrichtung 14 mit dem Klammerelement 28, und veranschaulicht einen beispielhaften Aufbau der Anzeigeflächeneinrichtung 14. Diese kann beispielsweise eine oder mehrere flexible Deckfolien 40 aufweisen, die zu beiden Seiten der Anzeigeflächeneinrichtung 14 angeordnet sein können, und die eine oder mehrere Leuchtelementschichten umfassen kann, wobei als Leuchtelementschicht 42 eine Fläche oder Schicht mit Leuchtelementen wie zum Beispiel OLEDs oder LEDs verstanden wird. Im Beispiel der Fig. 5c kann die Anzeigeflächeneinrichtung 14 zum Beispiel zwei Leuchtelementschichten 42 aufweisen, die zum Beispiel durch eine Trägerschicht 44 getrennt sein können. Eine solche Trägerschicht 44 kann aus einem geeigneten Trägermaterial für die Leuchtelementschichten 42 bestehen oder ein solches aufweisen.

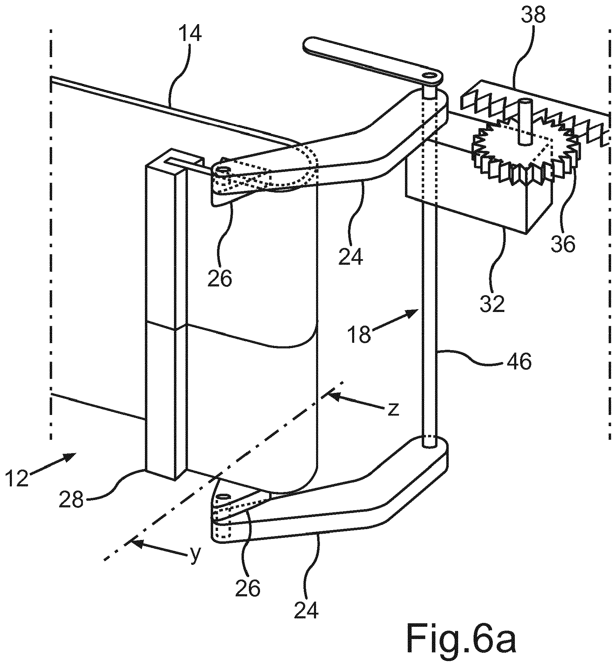

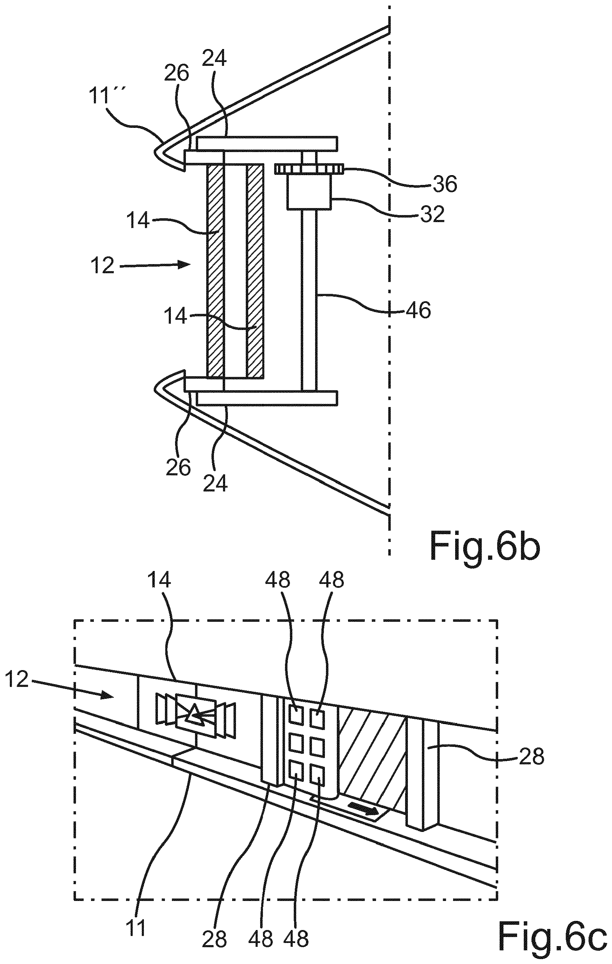

Die Fig. 6a, 6b, und 6c anschaulichen ein weiteres Ausführungsbeispiel die erfindungsgemäßen Anzeigevorrichtung 12, wobei das Klammerelement 28 beispielsweise als ein die Anzeigeflächeneinrichtung 14 umfassenden Steg ausgestaltet sein kann. Die Falteinrichtung 18 kann dabei zum Beispiel der in den Fig. 5a, 5b und 5c dargestellten Falteinrichtung 18 weitestgehend gleichen, wobei im Folgenden auf die Unterschiede eingegangen wird. In dem Beispiel der Fig. 6a kann das Hebelelement 24 beispielsweise zwei Hebel aufweisen, die jeweils seitlich von der Anzeigeflächeneinrichtung 14 angelegt und jeweils mit einem Halteelement 26 verbunden sein können, wobei jedes der Halteelemente 26 an einer seitlichen Kante der Anzeigeflächeneinrichtung 14 angeordnet sein kann. Die beiden Hebel des Hebelelements 24 können dabei beispielsweise über einen Steg 46 miteinander verbunden sein.

Die Fig. 6b zeigt einen Schnitt entlang der in der Fig. von 6a gezeigten Schnittlinie Y-Z. Die Anzeigevorrichtung 12 kann beispielsweise an einer Schalttafel 11" angeordnet sein, zum Beispiel angeklebt oder angeschraubt sein. Die Anzeigeflächeneinrichtung 14 ist dabei in einem gefalteten Zustand gezeigt.

Die Fig. 6b veranschaulicht ein Ausführungsbeispiel einer eingefalteten oder eingeklappten Anzeigeflächeneinrichtung 14, wobei auf der Anzeigefläche 16 Anzeigeelemente 48 zu sehen sind. Diese Anzeigeelemente 48 können beispielsweise zum Bedienen eines Radios oder einer Klimaanlage oder einer anderen Funktion des Kraftfahrzeugs verwendet werden. Aus Gründen der Übersichtlichkeit wurden in der Fig. 6c nicht alle Anzeigeelemente 48 mit Bezugszeichen versehen. Die schraffierte Fläche zeigt dabei die Ausdehnung der Anzeigeflächeneinrichtung 14 in einem ausgeklappten Zustand.

Die oben beschriebenen Ausführungsbeispiele veranschaulichen das Prinzip der Erfindung, eine Anzeigevorrichtung 12 bereitzustellen, bei der eine Anzeigeflächeneinrichtung 14 durch einfaches Aufblättern oder Aufklappen oder Entfalten vergrößert werden kann.

Eine solche Anzeigevorrichtung 12 kann zum Beispiel als "Falt-Display" bezeichnet werden und ermöglicht einem Benutzer, beispielsweise einem Fahrer, mehrere Variationen, verschiedene Inhalte zur gleichen Zeit darzustellen. Der Bauraum ermöglicht zum Beispiel eine doppelte Anzeigegröße durch ein Überlagern der Faltflächen, also der Anzeigenbereiche A, B oder des Anzeigebereichs A, B. Die Anzeigevorrichtung 12 kann auch für einen Beifahrer wichtig sein, um für ihn zusätzliche Inhalte anzeigen lassen zu können, ohne Einstellungen eines Fahrers zu stören.

Vorteilhaft dominiert eine solche Anzeigevorrichtung 12, zum Beispiel ein Display, nicht unnötig in einem Innenraum des Kraftfahrzeugs. Beispielsweise kann, gemäß einem weiteren Ausführungsbeispiel, ein 100 % Screen plus 100 % Screen bereitgestellt werden, mit anderen Worten eine doppelte Anzeigefläche 16. Ein Klappwinkel kann dabei frei wählbar sein. Die Anzeigevorrichtung 12 kann zum Beispiel als zusätzliches Beifahrer-Display genutzt werden. Ein Kraftfahrzeughersteller kann sich hierdurch zu einem Mitbewerber unterscheiden. Außerdem wird ein Innenraum des Kraftfahrzeugs 10 aufgeräumt.

## Patentansprüche

1. Anzeigevorrichtung (12) für ein Kraftfahrzeug (10), aufweisend eine Anzeigeflächeneinrichtung (14) mit einer Anzeigefläche (16) zum Anzeigen eines Anzeigeninhaltes, die Anzeigevorrichtung (12) aufweisend:
- mindestens zwei Anzeigebereiche (A, B) der Anzeigeflächeneinrichtung (14), und
- eine Falteinrichtung (18), die dazu eingerichtet ist, die Anzeigeflächeneinrichtung (14) zu falten,
wobei die Falteinrichtung (18) **dadurch gekennzeichnet ist, dass** sie aufweist:
- ein Schienenelement (22), das parallel zu einer Erstreckungsrichtung eines der Anzeigebereiche (A, B) verläuft und parallel hierzu verschiebbar angeordnet ist,
- ein Hebelelement (24), das ein erstes Ende (25) und ein zweites Ende (23) aufweist, wobei das erste Ende (25) an dem Schienenelement (22) angeordnet ist, und
- mindestens ein Halteelement (26), das an dem anderen Anzeigebereich (A, B), der faltbar ist, und an dem zweiten Ende (23) des Hebelelements (24) angeordnet ist.

2. Anzeigevorrichtung (12) nach einem der vorhergehenden Ansprüche, **dadurch gekennzeichnet, dass** das mindestens eine Halteelement (26) an einer dem Schienenelement (22) zugewandten Seite des faltbaren Anzeigebereichs (16) und/oder an einem freien Ende und/oder an einer Kante des faltbaren Anzeigebereichs (A, B) angeordnet ist.

3. Anzeigevorrichtung (12) nach einem der vorhergehenden Ansprüche, **dadurch gekennzeichnet, dass** ein erstes Ende des Schienenelements (22) und der faltbare Anzeigenbereich (A, B), an dem das Halteelement (26) angeordnet ist, auf der gleichen Seite der Anzeigeflächeneinrichtung (14) angeordnet sind.

4. Anzeigevorrichtung (12) nach einem der vorhergehenden Ansprüche, **dadurch gekennzeichnet, dass** die Falteinrichtung (18) ein Klammerelement (28) aufweist, das einen Teilbereich eines Endes der Anzeigeflächeneinrichtung (14) umfasst.

5. Anzeigevorrichtung (12) nach einem der vorhergehenden Ansprüche, **gekennzeichnet durch**
- eine Steuereinrichtung (20), die dazu eingerichtet ist, in Abhängigkeit von einem eine Bedienhandlung beschreibenden Bediensignal einen durch das Bediensignal beschriebenen Klappwinkel zwischen beiden Anzeigebereichen (A, B) der Anzeigeflächeneinrichtung (14) einzustellen (S3).

6. Kraftfahrzeug (10), **gekennzeichnet durch** eine Anzeigevorrichtung (12) nach einem der vorhergehenden Ansprüche, vorzugsweise wobei die Anzeigeflächeneinrichtung (14) in einer Schalttafel und/oder in einer Mittelkonsole des Kraftfahrzeugs (10) angeordnet ist.

7. Verfahren zum Betreiben einer Anzeigevorrichtung (12) nach Anspruch 5, aufweisend die Schritte:
- Empfangen eines Bediensignals durch die Steuereinrichtung (20) der Anzeigevorrichtung (S1),
- in Abhängigkeit von dem empfangenen Bediensignal Erzeugen eines Steuersignals zum Steuern der Falteinrichtung (18, S2), und
- in Abhängigkeit von dem Steuersignal Einstellen eines Klappwinkels zwischen beiden Anzeigebereichen (A, B) durch die Steuereinrichtung (20, S3).

## Claims

1. Display device (12) for a motor vehicle (10), having a display surface apparatus (14) with a display surface (16) for displaying a display content, the display device (12) having:
- at least two display regions (A, B) of the display surface apparatus (14), and
- a folding apparatus (18), which is designed to fold the display surface apparatus (14),
wherein the folding apparatus (18) is **characterised in that** it has:
- a rail element (22), which runs parallel to a direction of extension of one of the display regions (A, B) and is arranged movably parallel to it,
- a lever element (24), which has a first end (25) and a second end (23), wherein the first end (25) is arranged on the rail element (22), and
- at least one retaining element (26), which is arranged on the other display region (A, B), which is foldable, and on the second end (23) of the lever element (24).

2. Display device (12) according to any of the preceding claims,
**characterised in that**
the at least one retaining element (26) is arranged on a side of the foldable display region (16) facing the rail element (22) and/or on a free end and/or on an edge of the foldable display region (A, B).

3. Display device (12) according to any of the preceding claims,
**characterised in that**
a first end of the rail element (22) and the foldable display region (A, B), on which the retaining element (26) is arranged, are arranged on the same side of the display surface apparatus (14).

4. Display device (12) according to any of the preceding claims,
**characterised in that**
the folding apparatus (18) has a clamp element (28), which surrounds a section of one end of the display surface apparatus (14).

5. Display device (12) according to any of the preceding claims,
**characterised by**
- a control apparatus (20), which is designed, on the basis of an operating signal describing an operational action, to adjust (S3) a flexible angle between the two display regions (A, B) of the display surface apparatus (14) described by the operating signal.

6. Motor vehicle (10) **characterised by** a display device (12) according to any of the preceding claims, wherein the display surface apparatus (14) is preferably arranged in a dashboard and/or in a centre console of the motor vehicle (10).

7. Method for operating a display device (12) according to claim 5, comprising the steps of:
- Receiving an operating signal by the control apparatus (20) of the display device (S1), and
- On the basis of the operating signal received, generating a control signal to control the folding apparatus (18, S2), and
- On the basis of the control signal, adjusting a flexible angle between the two display regions (A, B) by means of the control apparatus (20, S3).

## Revendications

1. Dispositif d'affichage (12) pour un véhicule automobile (10), présentant un dispositif de surface d'affichage (14) avec une surface d'affichage (16) pour afficher un contenu d'affichage, le dispositif d'affichage (12) présentant :
- au moins deux zones d'affichage (A, B) du dispositif de surface d'affichage (14), et
- un dispositif de pliage (18) configuré pour plier le dispositif de surface d'affichage (14),
dans lequel le dispositif de pliage (18) est **caractérisé en ce qu'**il présente :
- un élément de rail (22) qui s'étend parallèlement à une direction d'extension de l'une des zones d'affichage (A, B) et est disposé de manière déplaçable parallèlement à celle-ci,
- un élément de levier (24) qui présente une première extrémité (25) et une seconde extrémité (23), dans lequel la première extrémité (25) est disposée sur l'élément de rail (22), et
- au moins un élément de maintien (26) qui est disposé sur l'autre surface d'affichage (A, B), qui est pliable, et sur la seconde extrémité (23) de l'élément de levier (24).

2. Dispositif d'affichage (12) selon l'une quelconque des revendications précédentes, **caractérisé en ce que**
l'au moins un élément de maintien (26) est disposé sur un côté de la zone d'affichage pliable (16) tourné vers l'élément de rail (22) et/ou sur une extrémité libre et/ou sur un bord de la zone d'affichage pliable (A, B).

3. Dispositif d'affichage (12) selon l'une quelconque des revendications précédentes, **caractérisé en ce**
**qu'**une première extrémité de l'élément de rail (22) et la zone d'affichage pliable (A, B), sur laquelle l'élément de maintien (26) est disposé, sont disposées du même côté du dispositif de surface d'affichage (14).

4. Dispositif d'affichage (12) selon l'une quelconque des revendications précédentes, **caractérisé en ce que** le dispositif de pliage (18) présente un élément de serrage (28) qui comprend une zone partielle d'une extrémité du moyen de surface d'affichage (14).

5. Dispositif d'affichage (12) selon l'une quelconque des revendications précédentes, **caractérisé par**
- un dispositif de commande (20), qui est configuré pour régler (S3) un angle de pliage décrit par le signal de commande entre les deux zones d'affichage (A, B) du dispositif de surface d'affichage (14) en fonction d'un signal de commande décrivant une action de commande.

6. Véhicule automobile (10), **caractérisé par** un dispositif d'affichage (12) selon l'une quelconque des revendications précédentes, de préférence dans lequel le dispositif de surface d'affichage (14) est disposé dans un tableau de commande et/ou dans une console centrale du véhicule automobile (10).

7. Procédé de fonctionnement d'un dispositif d'affichage (12) selon la revendication 5, présentant les étapes consistant à :
- recevoir un signal de commande par le dispositif de commande (20) du dispositif d'affichage (S1),
- en fonction du signal de commande reçu, générer un signal de commande pour commander le dispositif de pliage (18, S2), et
- en fonction du signal de commande, régler un angle de pliage entre les deux zones d'affichage (A, B) par le dispositif de commande (20, S3).
